# EUROPEAN PATENT APPLICATION

(11) **EP 4 831 969 A1**
(43) Date of publication of application: **28.10.2026**
(21) Application number: 26172483.5
(22) Date of filing: 15.04.2026
(51) Int. Cl.: G09F 3/20, G09F 9/37

(54) **ELECTRONIC SHELF LABEL AND METHOD FOR MANUFACTURING ELECTRONIC SHELF LABEL**

(30) Priority: 25.04.2025 KR 20250054300
(71) Applicant: SOLUM CO., LTD., Gyeonggi-do 16914 (KR)
(72) Inventor: SEO, Bo Yle, 16505 Suwon-si (KR); KIM, Kwang Hyun, 15010 Siheung-si (KR); JUNG, Keun Hwa, 18457 Hwaseong-si (KR); KIM, Tae Hoon, 16902 Yongin-si (KR); CHO, Koon Shik, 13835 Gwacheon-si (KR)
(74) Representative: Kraus & Lederer PartGmbB

(57) **Abstract**

Provided is an electronic shelf label including a display device (110) controlled to display information regarding a product, a printed circuit board (120) provided on a rear surface of the display device (110) and electrically connected to the display device (110), and having at least one component provided on one surface, a front cover (130) provided on a front surface of the display device (110), a molding layer provided on the rear surface of the display device (110), and a rear cover (150) provided on the rear surface of the display device (110) and coupled with the front cover (130).

## Description

### TECHNICAL FIELD

**.** The present disclosure relates to an electronic shelf label and a method for manufacturing the electronic shelf label, and more specifically, to an electronic shelf label and a method for manufacturing the electronic shelf label to improve the durability of a printed circuit board and/or a display device included in the electronic shelf label using a molding layer.

### BACKGROUND

**.** The use of electronic labels is gradually expanding in application fields such as displaying information on products displayed in stores. Electronic labels, also known as electronic shelf labels or electronic tags, are connected to a server via a gateway to receive product information to be displayed and display the received product information on an electronic paper display. The use of electronic paper displays is expanding because they operate at low power, allowing for extended battery life, and display information can be changed via a communication network, thereby reducing labor costs for store management.

**.** When a new product is displayed on a shelf, a procedure to assign the new product to an electronic shelf label is required such that the electronic shelf label can display the information of the product. Generally, when a store manager reads a barcode attached to an electronic label with a terminal and then reads the product barcode and transmits the same to a server, the server assigns the corresponding electronic shelf label to the product, registers the same in a database, and transmits product-related information to the electronic shelf label such that the display is changed.

**.** An electronic shelf label includes a display device for displaying product information, a printed circuit board containing an IC chip that drives the display device, a battery that supplies power to the printed circuit board, and a housing for protecting these components.

**.** Such electronic shelf labels are placed on the front of shelves where products are displayed and have the function of providing product information to store customers via display devices. Since countless products can be displayed on shelves within a store and display states thereof vary according to sales strategies, the positions of the electronic shelf labels also need to be dynamically changed.

**.** For efficient management of countless electronic shelf labels corresponding to countless products displayed within a store, weight-lighting technology for individual electronic shelf labels is critical. Furthermore, if a technical defect occurs in an electronic shelf label while the electronic shelf label is mounted on a shelf, it is very cumbersome for a manager to repair only the defective label among countless labels in the store, which can lead to a decrease in store management efficiency.

**.** Accordingly, in order to improve the efficiency of store management utilizing electronic shelf labels, there is a need for research on technology capable of reducing the weight of electronic labels and simultaneously enhancing the durability thereof.

### [Prior Art Document]

### [Patent Document]

**.** (Patent Document 1) US 15-060924
**.** (Patent Document 2) KR 2019-0035936

### SUMMARY

**.** The present disclosure provides an electronic shelf label and a method for manufacturing the electronic shelf label to improve the durability of a printed circuit board and/or a display device included in the electronic shelf label using a molding layer.

**.** The present disclosure also provides a lightweight electronic shelf label and a method for manufacturing the electronic shelf label by minimizing the number of internal components.

**.** However, the technical objects to be achieved by the various embodiments of the present disclosure are not limited to the technical objects described above, and other technical objects may exist.

**.** In an aspect, an electronic shelf label includes a display device controlled to display information regarding a product, a printed circuit board provided on a rear surface of the display device and electrically connected to the display device, and having at least one component provided on one surface, a front cover provided on a front surface of the display device, a molding layer provided on the rear surface of the display device, and a rear cover provided on the rear surface of the display device and coupled with the front cover.

**.** In another aspect, the printed circuit board may be provided on the rear surface of the display device, and the molding layer may cover a rear surface of the printed circuit board.

**.** In another aspect, the area of the rear surface of the printed circuit board may be smaller than the area of the rear surface of the display device, and the molding layer may cover both the rear surface of the printed circuit board and the rear surface of the display device.

**.** In another aspect, the side of the display device and the side of the molding layer may be provided on the same plane.

**.** In another aspect, the molding layer may have a first height for an area corresponding to a first area of the printed circuit board and have a second height different from the first height for an area corresponding to a second area different from the first area of the printed circuit board.

**.** In another aspect, the height of at least one first component provided in the first area of the printed circuit board may be lower than the height of at least one second component provided in the second area of the printed circuit board, and the first height of the molding layer may be lower than the second height of the molding layer.

**.** In another aspect, the molding layer may cover the rear surface of the display device, and the printed circuit board may be provided on the rear surface of the molding layer.

**.** In another aspect, the electronic shelf label may further include an additional molding layer covering the rear surface of the printed circuit board.

**.** In another aspect, the additional molding layer may have a first height for an area corresponding to a first area of the printed circuit board, and have a second height different from the first height for an area corresponding to a second area different from the first area of the printed circuit board.

**.** In another aspect, the height of at least one first component provided in the first area of the printed circuit board may be lower than the height of at least one second component provided in the second area of the printed circuit board, and the first height of the additional molding layer may be lower than the second height of the molding layer.

**.** In an aspect, a method for manufacturing an electronic shelf label controlled by a server to display information regarding a product includes connecting a display device and a printed circuit board, forming a molding layer on a rear surface of the printed circuit board, providing a front cover on a front surface of the display device, and coupling a rear cover covering the rear surface of the display device with the front cover.

**.** In another aspect, the forming a molding layer may include measuring a first height of at least one first component provided in a first area of the printed circuit board, adjusting the height of a molding material supply device based on the first height and spraying a molding material onto the at least one first component, measuring a second height of at least one second component provided in a second area different from the first area of the printed circuit board, adjusting the height of the molding material supply device based on the second height and spraying the molding material onto the at least one second component, and curing the molding material sprayed onto the at least one first component and the at least one second component.

**.** According to various embodiments of the present disclosure, it is possible to provide an electronic shelf label with improved durability and a method for manufacturing the electronic shelf label by applying a molding layer that covers a printed circuit board and/or a display device included in the electronic shelf label.

**.** According to various embodiments of the present disclosure, it is possible to provide a lightweight electronic shelf label and a method for manufacturing the electronic shelf label by connecting a printed circuit board and a display device included in the electronic shelf label through a flexible connection structure to form an assembly and covering one side of the assembly by a molding layer, thereby eliminating the need for a separate additional housing structure for protecting the assembly becomes unnecessary.

**.** However, the effects that can be obtain through the various embodiments of the present disclosure are not limited to those mentioned above, and other effects not mentioned can be clearly understood from the description below.

### [BRIEF DESCRIPTION OF THE DRAWINGS]

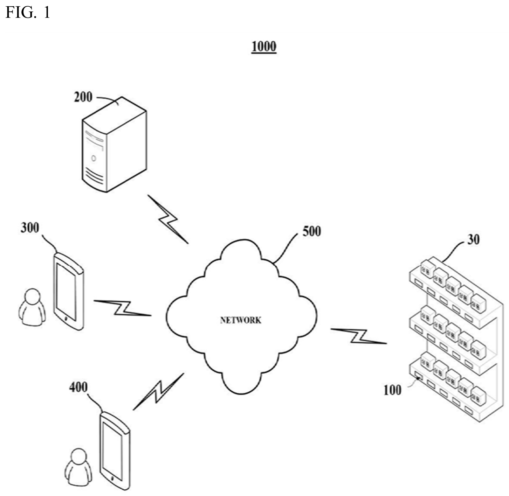

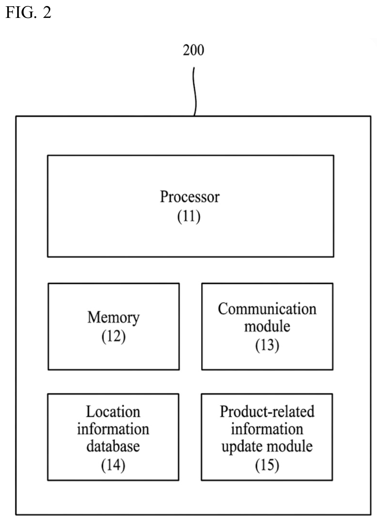

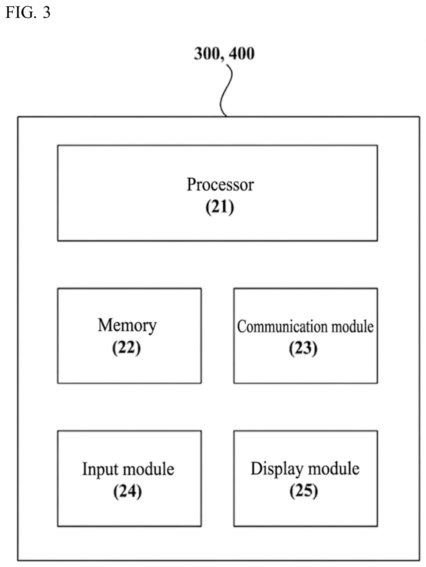

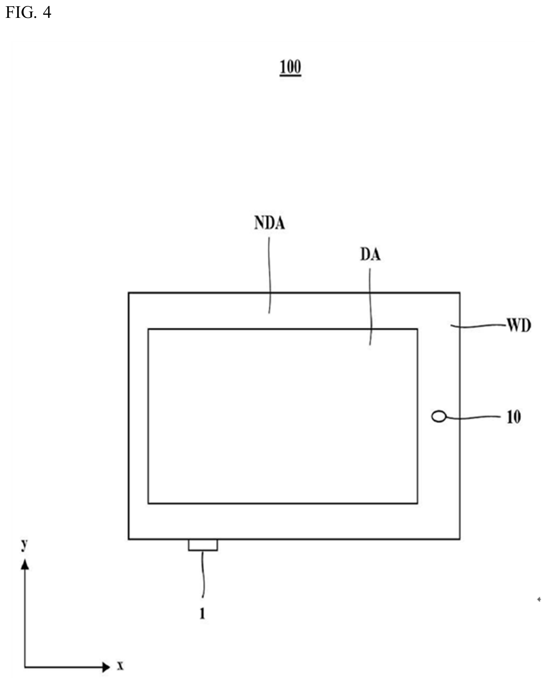

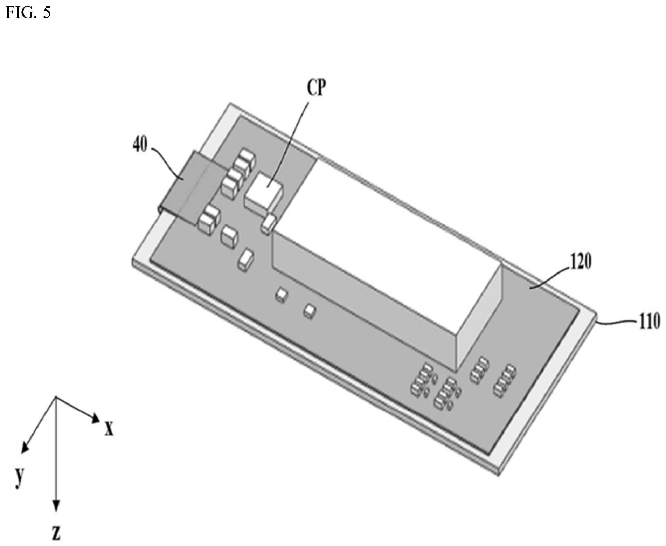

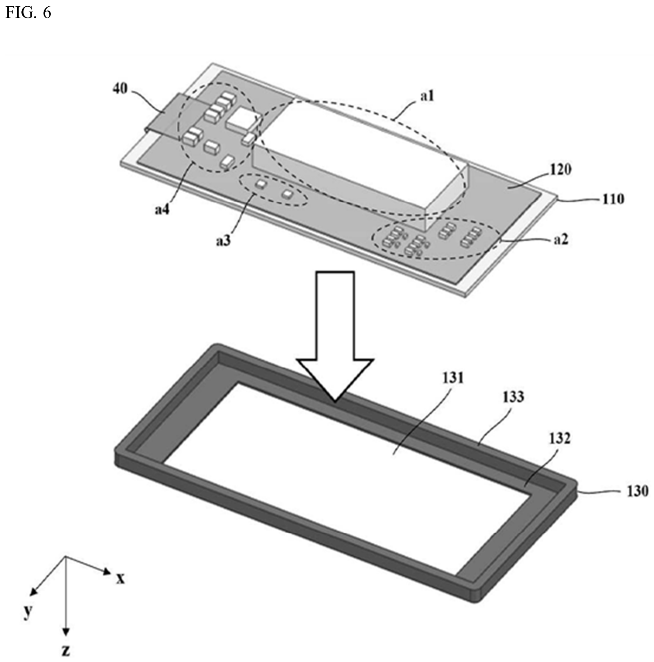

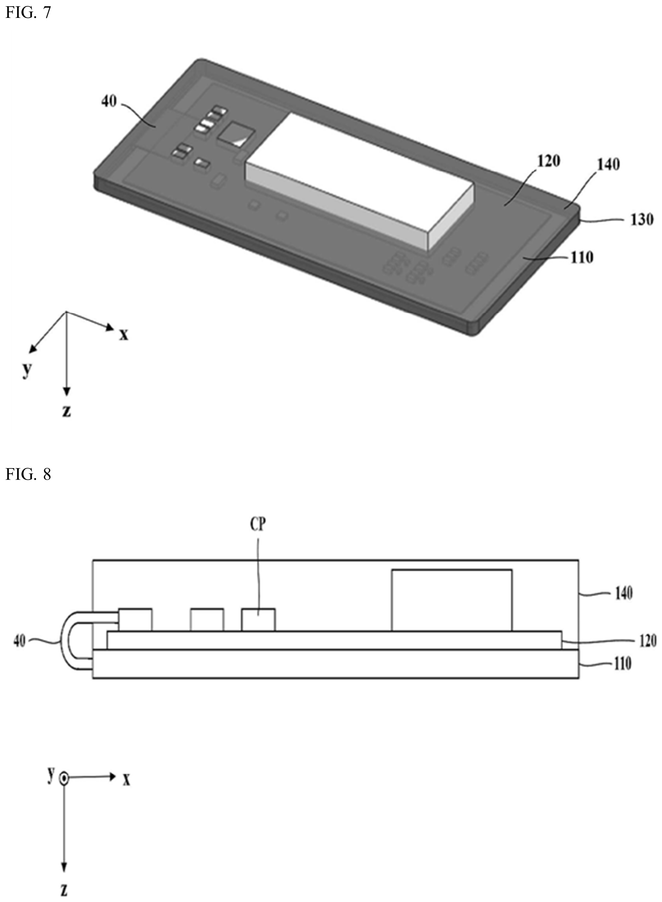

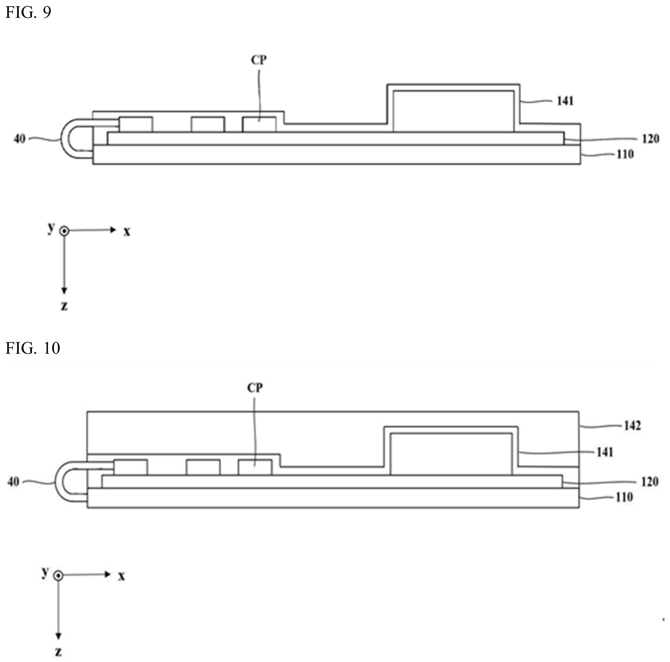

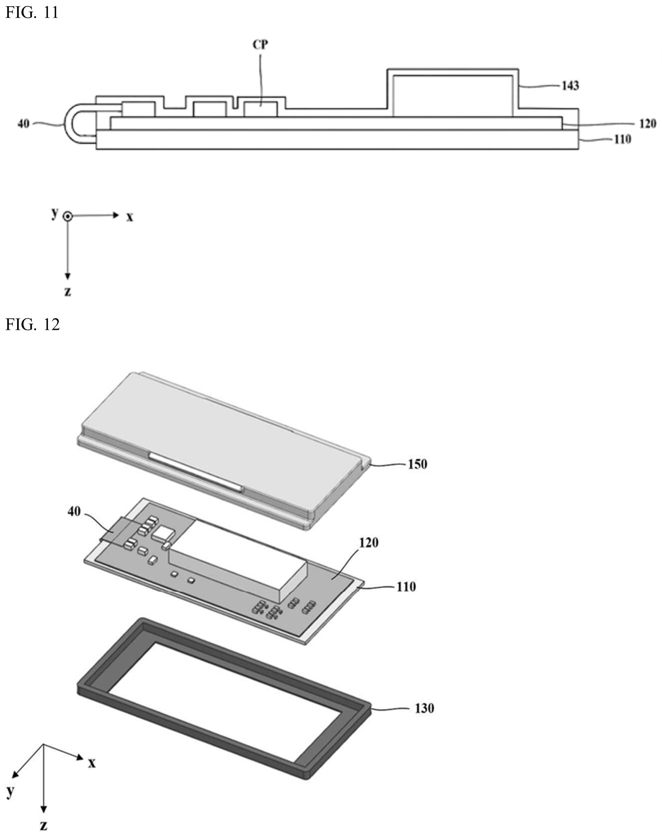

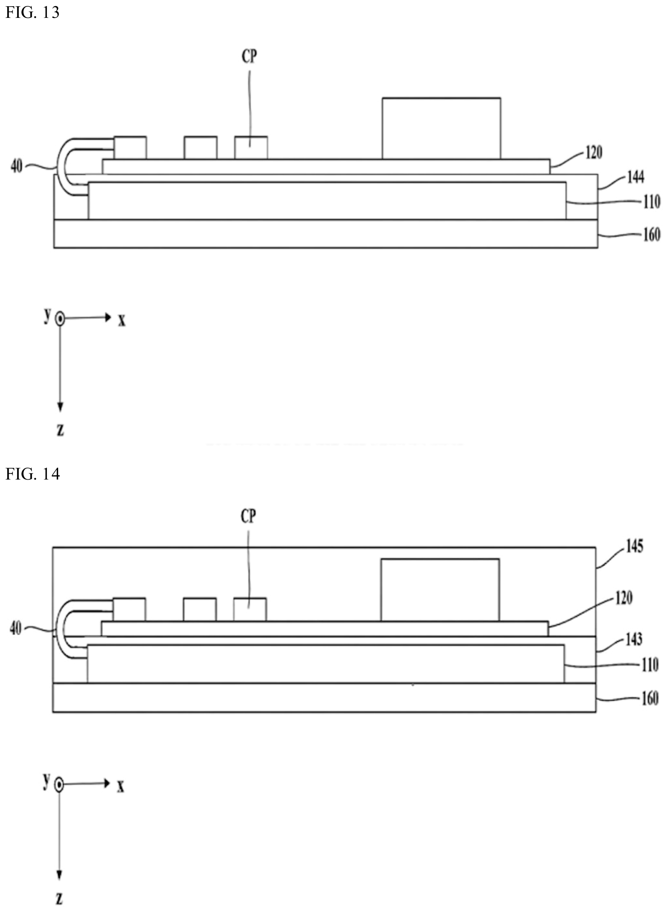

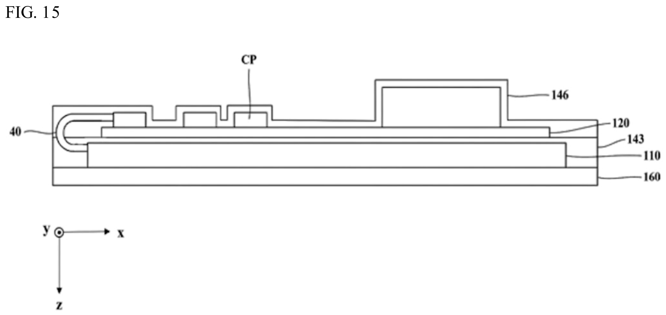

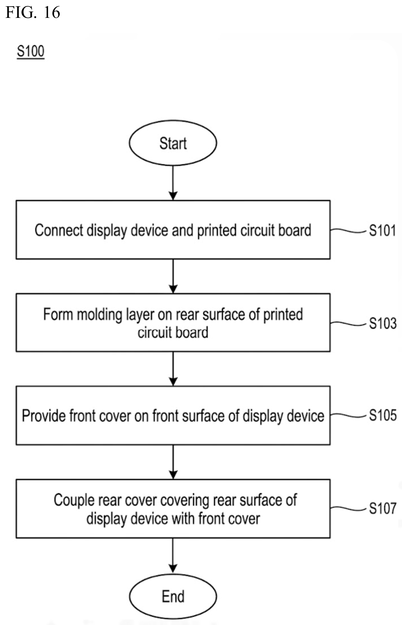

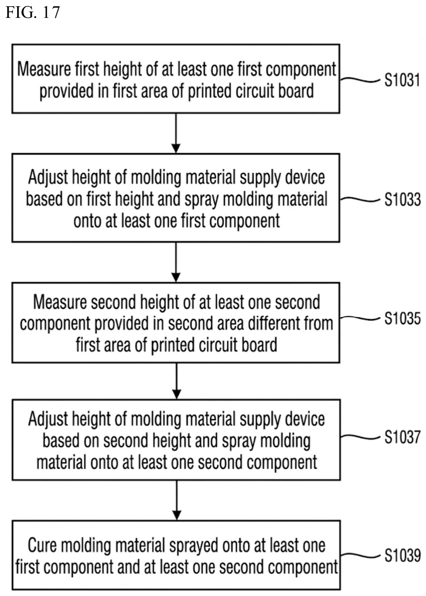

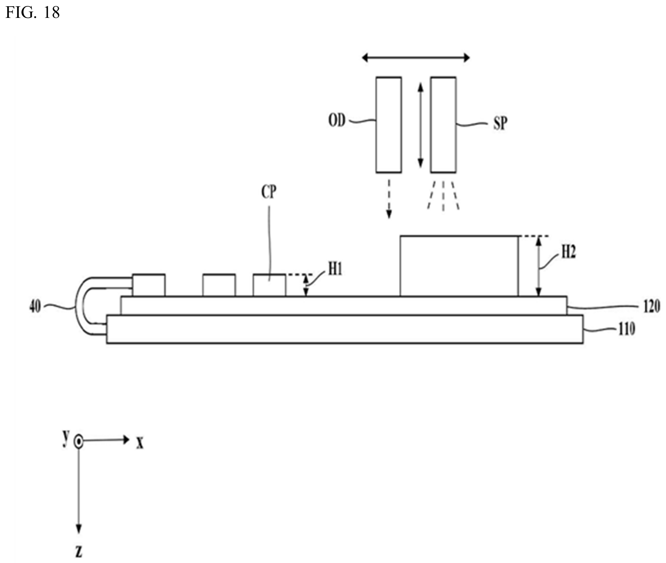

**.** FIG. 1 illustrates an exemplary configuration of an electronic shelf label system that displays product-related information according to an embodiment.
**.** FIG. 2 is a block diagram illustrating an exemplary configuration of a server according to an embodiment.
**.** FIG. 3 is a block diagram illustrating an exemplary configuration of a computing device according to an embodiment.
**.** FIG. 4 is a front view illustrating an exemplary configuration of an electronic shelf label according to an embodiment.
**.** FIG. 5 illustrates an exemplary configuration of an assembly included in the electronic shelf label according to an embodiment.
**.** FIG. 6 illustrates a method of combining an assembly included in an electronic shelf label according to an embodiment with a front cover.
**.** FIG. 7 illustrates the formation of a molding layer on the assembly included in the electronic shelf label according to an embodiment.
**.** FIG. 8 illustrates a configuration of the molding layer included in the electronic shelf label according to an embodiment.
**.** FIG. 9 illustrates a configuration of a molding layer included in the electronic shelf label according to another embodiment.
**.** FIG. 10 illustrates a configuration of an additional molding layer included in the electronic shelf label according to an embodiment.
**.** FIG. 11 illustrates a configuration of a molding layer included in the electronic shelf label according to another embodiment.
**.** FIG. 12 illustrates a method of combining the front cover and a rear cover included in the electronic shelf label according to an embodiment.
**.** FIG. 13 illustrates a configuration of a molding layer included in the electronic shelf label according to another embodiment.
**.** FIG. 14 illustrates a configuration of an additional molding layer included in the electronic shelf label according to another embodiment.
**.** FIG. 15 illustrates a configuration of an additional molding layer included in the electronic shelf label according to another embodiment.
**.** FIG. 16 is a flowchart of a method for manufacturing an electronic shelf label according to an embodiment.
**.** FIG. 17 is a flowchart illustrating steps included in the step of forming a molding layer included in the method for manufacturing an electronic shelf label according to an embodiment.
**.** FIG. 18 illustrates a method for forming a molding layer included in an electronic shelf label according to an embodiment.

### [DETAILED DESCRIPTION]

**.** The present disclosure is capable of various modifications and embodiments. Therefore, specific embodiments are illustrated in the drawings and described in detail in the detailed description. The effects and features of the present disclosure, as well as the methods for achieving the same, will become clear with reference to the embodiments described in detail below together with the drawings. However, the present disclosure is not limited to the embodiments disclosed below and can be implemented in various forms. In the following embodiments, terms such as "first" and "second" are not used in a limiting sense but are used for the purpose of distinguishing one component from another. Furthermore, the singular expression includes plural expressions unless the context clearly indicates otherwise. Furthermore, terms such as "include" and "have" indicate the presence of a feature or component described in the specification, and do not preemptively exclude the possibility of one or more other features or components being added. Furthermore, the sizes of components in the drawings may be exaggerated or reduced for convenience of explanation. For example, the size and thickness of each component shown in the drawings are arbitrarily shown for convenience of explanation, and thus the present disclosure is not necessarily limited to what is shown.

**.** Hereinafter, embodiments of the present disclosure will be described in detail with reference to the attached drawings. When describing with reference to the drawings, identical or corresponding components are denoted by the same reference numerals and redundant descriptions thereof will be omitted.

**.** FIG. 1 illustrates an exemplary configuration of an electronic shelf label system 1000 that displays product-related information according to an embodiment. FIG. 2 is a block diagram illustrating an exemplary configuration of a server 200 according to an embodiment. FIG. 3 is a block diagram illustrating an exemplary configuration of a computing device 300 and 400 according to an embodiment. FIG. 4 is a front view illustrating an exemplary configuration of an electronic shelf label 100 according to an embodiment. FIG. 5 illustrates an exemplary configuration of an assembly included in the electronic shelf label 100 according to an embodiment. FIG. 6 illustrates a method of combining an assembly included in an electronic shelf label 100 according to an embodiment with a front cover 130. FIG. 7 illustrates the formation of a molding layer 140 on the assembly included in the electronic shelf label 100 according to an embodiment. FIG. 8 illustrates a configuration of the molding layer 140 included in the electronic shelf label 100 according to an embodiment. FIG. 9 illustrates a configuration of a molding layer 141 included in the electronic shelf label 100 according to another embodiment. FIG. 10 illustrates a configuration of an additional molding layer 142 included in the electronic shelf label 100 according to an embodiment. FIG. 11 illustrates a configuration of a molding layer 143 included in the electronic shelf label 100 according to another embodiment. FIG. 12 illustrates a method of combining the front cover 130 and a rear cover 150 included in the electronic shelf label 100 according to an embodiment. FIG. 13 illustrates a configuration of a molding layer 144 included in the electronic shelf label 100 according to another embodiment. FIG. 14 illustrates a configuration of an additional molding layer 145 included in the electronic shelf label 100 according to another embodiment. FIG. 15 illustrates a configuration of an additional molding layer 146 included in an electronic shelf label 100 according to another embodiment. FIG. 16 is a flowchart of a method S100 for manufacturing an electronic shelf label according to an embodiment. FIG. 17 is a flowchart illustrating steps included in the step S103 of forming a molding layer included in the method S100 for manufacturing an electronic shelf label according to an embodiment. FIG. 18 illustrates a method for forming the molding layer 140 included in the electronic shelf label 100 according to an embodiment.

### . - System 1000

**.** Referring to FIG. 1, the system 1000 may include electronic shelf labels 100 provided on a shelf 30, a server 200, and computing devices 300 and 400. The computing devices 300 and 400 may include portable user terminals.

**.** The electronic shelf labels 100 included in the system 1000 may be linked with the server 200, and product-related information displayed on the electronic shelf labels 100 may be updated by the server 200.

**.** Data of updated product-related information is transmitted from the server 200 to the electronic shelf label 100, and the electronic shelf labels 100 may display the updated product-related information. In this case, the server 200 may update the product-related information based on user input through the computing devices 300 and 400.

**.** For example, a plurality of electronic shelf labels 100 and a plurality of products may be provided on the shelf 30. The plurality of products may be respectively assigned to the plurality of electronic shelf labels 100.

**.** A first product may be assigned to any first electronic shelf label among the plurality of electronic shelf labels 100, and a second product different from the first product may be assigned to a second electronic shelf label. The first electronic shelf label and the first product may be provided adjacent to each other, and the second electronic shelf label and the second product may be provided adjacent to each other.

**.** The server 200 may update information regarding the plurality of products assigned to the plurality of electronic shelf labels 100. The server 200 may update the information regarding the plurality of products collectively and transmit the updated information regarding the plurality of products to the plurality of electronic shelf labels 100.

**.** For example, the server 200 can update the information regarding any first product among the products and transmit the updated information regarding the first product to the first electronic shelf label to which the first product is assigned.

**.** Additionally, the server 200 can update information regarding the second product among the products and transmit the updated information regarding the second product to the second electronic shelf label to which the second product is assigned.

**.** The electronic shelf labels 100, the server 200, and the computing devices 300 and 400 can be connected through a network 500. Here, the network 500 according to the embodiment may refer to a connection architecture through which information can be exchanged between nodes such as the electronic shelf labels 100, the server 200, and the computing devices 300 and 400. For example, the network 500 may include, but is not limited to, a 3GPP (3rd Generation Partnership Project) network, an LTE (Long Term Evolution) network, a WIMAX (World Interoperability for Microwave Access) network, the Internet, a LAN (Local Area Network), a Wireless LAN (Wireless Local Area Network), a WAN (Wide Area Network), a PAN (Personal Area Network), a Bluetooth network, a satellite broadcasting network, an analog broadcasting network, a DMB (Digital Multimedia Broadcasting) network, etc.

**.** The electronic shelf labels 100 may be wirelessly connected to the server 200 through a separate gateway (not shown). However, the present disclosure is not limited thereto, and the electronic shelf labels 100 may be connected to the computing devices 300 and 400 via wireless communication. For example, the electronic shelf labels 100 may be paired with the computing devices 300 and 400 based on Bluetooth functionality.

**.** The electronic shelf labels 100 may be electronic devices provided on the shelf 30 to display information related to products displayed on the shelf 30. For example, each electronic shelf label 100 may display information related to a product, such as the Korean product name, English product name, product country of origin, product price, raw materials, and weight/calories of the product.

**.** The electronic shelf label 100 may include an electronic paper display (EPD) that maintains a product information display state even when power is not supplied. The electronic paper display is suitable for the electronic shelf label 100 which needs to reduce power consumption due to its bistability, which maintains the display state for a long period even when power supply is interrupted. Electronic paper displays include a twist ball type using a hemispherical twist ball charged with electrostatic charge, an electrophoretic display utilizing electrophoresis and microcapsules, and a cholesterol liquid crystal display using cholesterol liquid crystal.

**.** However, the present disclosure is not limited thereto, and the electronic shelf label 100 may include any one of a liquid crystal display (LCD), a thin film transistor-liquid crystal display (TFT-LCD), an organic light-emitting diode (OLED), a flexible display, and a 3D display.

**.** The server 200 may update information regarding a product assigned to an electronic shelf label 100 provided on the shelf 30 and transmit the updated information regarding the product to the electronic shelf label 100. In this case, the server 200 may update the information regarding the product based on user input received through the computing devices 300 and 400.

**.** More specifically, to update the information regarding the product assigned to the electronic shelf label 100, the server 200 may exchange necessary data with the electronic shelf label 100 and the computing devices 300 and 400. Accordingly, the server 200 can provide an environment necessary to update the information regarding the product.

**.** For example, the server 200 may provide an environment in which the information regarding the product can be updated using the computing devices 300 and 400 (e.g., a portable user terminal type computing device, a desktop type computing device, etc.). The server 200 may include an application, data and/or instructions for operation of a product-related information update application, and may transmit data based thereon to the computing devices 300 and 400.

**.** Additionally, the server 200 may provide a license key to the computing devices 300 and 400. The server 200 may provide an edit license key for granting the authority to update product-related information to the computing devices 300 and 400. For example, a customer or an on-site employee at a store may receive a service to update product-related information by using the computing devices 300 and 400 that has received the edit license key.

**.** Referring to FIG. 2, the server 200 may be implemented as a predetermined computing device including at least one processor 11 for data processing, a memory 12 for storing applications, data and/or instructions, at least one communication module 13 for exchanging data with external devices, a location information database 14 for storing location information of electronic shelf labels 100, and a product-related information update module 15 for updating product-related information.

**.** The processor 11 may control the overall operation of the components included in the server 200 to provide an environment in which a product-related information update application can operate in the computing devices 300 and 400.

**.** The processor 11 may be a system-on-chip (SoC) including a central processing unit (CPU) and/or a graphics processing unit (GPU), and may execute an operating system (OS) and/or an application program stored in the memory 12.

**.** In addition, the processor 11 may communicate internally with each component included in the server 200 via a system bus and may include one or more predetermined bus structures, including a local bus.

**.** Additionally, the processor 11 may be implemented using at least one of application specific integrated circuits (ASICs), digital signal processors (DSPs), digital signal processing devices (DSPDs), programmable logic devices (PLDs), field programmable gate arrays (FPGAs), controllers, microcontrollers, microprocessors, and other electrical units for performing functions.

**.** The memory 12 may store one or more of an operating system (OS), various application programs, data, and instructions for providing an environment necessary to perform a method of updating related information of a product.

**.** Additionally, the memory 12 may include a program area and a data area. Here, the program area according to an embodiment may be linked between the operating system (OS) that boot the server 200 and functional elements, and the data area may store data generated according to the use of the server 200.

**.** In an embodiment, memory 12 may be various storage devices such as a ROM, a RAM, an EPROM, a flash drive, and a hard drive and may be web storage that performs storage functions on the internet. Additionally, the memory 12 may be a recording medium that is attachable/detachable to/from the server 200.

**.** The communication module 13 may include various types of communication devices that enable the server 200 to transmit/receive data to/from an external device. The server 200 may transmit data based on an application, data and/or instructions for the product-related information update application to operate to the computing devices 300 and 400 via the communication module 13.

**.** The location information database 14 may store location information of the electronic shelf labels 100. A plurality of electronic shelf labels 100 may be provided on the shelf 30 to correspond to a plurality of products. Each of these electronic shelf labels 100 may be placed at a specific location on the shelf 30, and the location information of each electronic shelf label 100 on the shelf 30 may be stored in the location information database 14.

**.** For example, among the plurality of electronic shelf labels 100, the first electronic shelf label may be provided on the second row and third column of a first shelf provided in area A among a plurality of areas. In this case, the location information of the first electronic shelf label, "second row, third column of the first shelf in area A", can be stored in the location information database 14 as the location information of the first electronic shelf label, in association with a unique identification number of the first electronic shelf label.

**.** The product-related information update module 15 can update the product-related information displayed on the electronic shelf label 100. For example, the product-related information update module 15 may control the electronic shelf label 100 such that the product-related information displayed on the electronic shelf label 100 is periodically updated according to a product-related information update rules stored in the memory 12. The product-related information update rules stored in the memory 12 are predetermined by the user and can be modified at any time.

**.** However, the present disclosure is not limited thereto, and the product-related information update module 15 may also control the electronic shelf label 100 such that the product-related information displayed on the electronic shelf label 100 is updated according to user input for editing the product-related information.

**.** In the above description, the server 200 according to an embodiment performs functional operations as described above. However, according to various embodiments, at least some of the functional operations performed by the server 200 may be performed by an external device (e.g., the computing device 300 or 400), or the server 200 may further perform at least some of the functional operations performed by the external devices.

**.** The computing devices 300 and 400 may be devices in which the product-related information update application is installed. The computing devices 300 and 400 may include a portable user terminal. The computing devices 300 and 400 may be divided into a first computing device 300 and a second computing device 400 depending on the user.

**.** For example, the user of the first computing device 300 may be a store employee, and the user of the second computing device 400 may be a customer of the store. The first computing device 300 and the second The computing device 400 may have substantially the same structure.

**.** The computing devices 300 and 400 may be implemented, for example, as computers or portable terminals capable of connecting to the server 200 via the network 500. Here, computers may include, for example, a laptop, a desktop, a VR HMD (e.g., HTC VIVE, Oculus Rift, GearVR, DayDream, PSVR, etc.) equipped with a web browser, etc. Here, the VR HMD includes models for PC (e.g., HTC VIVE, Oculus Rift, FOVE, Deepon, etc.), mobile (e.g., GearVR, DayDream, Storm Mirror, Google Cardboard, etc.), console (PSVR), and stand-alone models implemented independently (e.g., Deepon, PICO, etc.). Portable terminals are, for example, wireless communication devices that ensure portability and mobility, such as a smartphone, a tablet PC, or a wearable device, various devices equipped with communication modules such as Bluetooth (BLE, Bluetooth Low Energy), NFC, RFID, Ultrasonic, Infrared, Wi-Fi, and Li-Fi.

**.** Referring to FIG. 3, the computing device 300 and 400 may include a processor 21, a memory 22, a communication module 23, an input module 24, and a display module 25. Various components included in the computing device 300 and 400 may be designed to be contained within the housing of the computing device 300 and 400.

**.** In an embodiment, the processor 21 may control the overall operation of the components included in the computing device 300 and 400 through the product-related information update application in the memory 22 to provide an environment for updating product-related information.

**.** For example, the processor 21 may control the operations of the communication module 23 and the input module 24 such that a signal corresponding to user input received through the input module 24 can be transmitted to the electronic shelf label 100 through the communication module 23.

**.** The processor 21 may include a central processing unit (CPU) and/or a graphics processing unit (GPU). Additionally, the processor 21 may include at least one of application specific integrated circuits (ASICs), digital signal processors (DSPs), digital signal processing devices (DSPDs), programmable logic devices (PLDs), field programmable gate arrays (FPGAs), controllers, microcontrollers, microprocessors, and other electrical units for performing functions.

**.** The memory 22 may store instructions and data that can be used to create an environment for updating product-related information. The product-related information update application may be stored in the memory 22. The product-related information update application may provide various types of user interfaces to provide an environment for updating product-related information.

**.** The memory 22 may include at least one non-transient computer-readable storage medium and a transient computer-readable storage medium. For example, the memory 22 may be various storage devices such as a ROM, an EPROM, a flash drive, and a hard drive. Additionally, the memory 22 may include a web storage that performs data storage functions on the internet.

**.** The communication module 23 may include various types of communication devices capable of transmitting/receiving data to/from an external device. For example, the communication module 23 may transmit/receive data to/from the electronic shelf label 100 and/or the server 200 via a wireless network.

**.** The communication module 23 may wirelessly transmit/receive data to/from at least one of a base station, an external terminal, or any server on a mobile communication network established through a communication device capable of performing technical standards for mobile communication or communication methods (e.g., LTE (Long Term Evolution), LTE-A (Long Term Evolution-Advanced), 5G NR (New Radio), Wi-Fi), or short-range communication methods.

**.** Additionally, the communication module 23 may be configured to transmit/receive data to/from an external electronic device via Bluetooth. For example, the communication module 23 may receive a pairing signal from the electronic shelf label 100 and be paired with the electronic shelf label 100 via Bluetooth.

**.** The input module 24 may be configured to receive various forms of user input from users using the computing devices 300 and 400. For example, the input module 24 may include a touch screen that receives touch input from a user. If the input module 24 is implemented as a touch screen, the input module 24 may be formed by being integrated with the display module 25. However, the present disclosure is not limited thereto, and the input module 24 may further include a keyboard capable of receiving user input in the form of characters.

**.** The display module 25 may display the product-related information update application stored in the memory 22. For example, the display module 25 may include a display device that displays various types of user interface (UI) images to provide an environment for updating product-related information.

**.** The display module 25 may include any one of a liquid crystal display (LCD), a thin film transistor-liquid crystal display (TFT LCD), an organic light-emitting diode (OLED), a flexible display, and a 3D display.

### . - Electronic shelf label 100

**.** Referring to FIG. 4, a window WD may be provided on the front of the electronic shelf label 100. The window WD may include a display area DA that is provided in a portion of the front of the electronic shelf label 100 and exposes product-related information and a non-display area NDA where product-related information is not displayed. The non-display area NDA may be a bezel area surrounding the display area DA.

**.** Additionally, the electronic shelf label 100 may include at least one button 1 and an LED 10. For example, the LED 10 may be provided in the non-display area NDA.

**.** The LED 10 may be controlled based on a signal from the server 200 or the computing devices 300 and 400. Additionally, the types of light colors emitted from the LED 10 may vary. For example, the light colors emitted from the LED 10 may include various colors such as blue, red, green, yellow, sky blue, gray, and white.

**.** The button 1 may be provided in a portion of the side of the electronic shelf label 100. However, the present disclosure is not limited thereto, and the button 1 may be provided on the front or back of the electronic shelf label 100.

**.** A pairing signal may be transmitted from the electronic shelf label 100 to the computing devices 300 and 400 according to user input through the button 1. Accordingly, the electronic shelf label 100 may be paired with the computing devices 300 and 400 based on Bluetooth.

**.** For example, when a user presses the button 1, a pairing signal is transmitted from the electronic shelf label 100 to the computing device 300 and 400, and the electronic shelf label 100 may be paired with the computing device 300 and 400 based on Bluetooth functionality.

**.** Referring to FIG. 5, the electronic shelf label 100 according to an embodiment may include an assembly in which a display device 110 and a printed circuit board 120 are electrically connected.

**.** Product-related information may be displayed on the front of the display device 110. The printed circuit board 120 may be provided on the rear side of the display device 110 and electrically connected to the display device 110.

. In this case, for example, the printed circuit board 120 may be connected to the display device 110 through a flexible connection structure 40. The flexible connection structure 40 may include at least one first terminal connected to an electrode of the display device 110 at one end and at least one second terminal connected to an electrode of the printed circuit board 120 at the other end.

**.** The flexible connection structure 40 may have elasticity such that it can bend. Accordingly, the display device 110 and the printed circuit board 120 may be electrically connected to each other by the bent flexible connection structure 40 in a state in which the display device 110 and the printed circuit board 120 area stacked. In this case, one end of the display device 110 and one end of the printed circuit board 120 located in an area where they overlap in the front-rear direction may be electrically connected to each other by the flexible connection structure 40.

**.** At least one component may be provided on the rear surface of the printed circuit board 120 that does not face the display device 110. For example, the printed circuit board 120 may include various types of components such as an IC chip for driving the display device 110, a plurality of resistor elements, a capacitor, and an inductor.

**.** In this case, the plurality of components provided on one side of the printed circuit board 120 may have various heights. For example, the heights of some components may be included in a first range, and the heights of other components may be included in a second range different from the first range.

**.** For example, referring to FIG. 6, the rear surface of the printed circuit board 120 may be divided into a plurality of areas a1, a2, a3, and a4 according to the heights of the components. Components provided in the first area a1 of the rear surface of the printed circuit board 120 may have heights belonging to the first range, components provided in the second area a2 may have heights belonging to the second range, components provided in the third area a3 may have heights belonging to a third range, and components provided in the fourth area a4 may have heights belonging to a fourth range.

. The assembly in which the display device 110 and the printed circuit board 120 are combined may be provided on a front cover 130. For example, referring to FIG. 6, the display device 110 and the front cover 130 may be combined such that the front surface of the display device 110 contacts the rear side of the front cover 130.

**.** The front of the front cover 130 may include a transparent portion 131 that exposes product-related information displayed on the display device 110, a bezel portion 132 surrounding the transparent portion 131, and a protrusion 133 formed to protrude toward the rear side along the perimeter of the bezel portion 132.

**.** In this case, the front edge of the display device 110 may come into contact with the rear side of the bezel portion 132 of the front cover 130, and an adhesive member may be provided therebetween such that the display device 110 and the bezel portion 132 can be joined together. Here, the adhesive member may include a double-sided tape.

**.** Referring to FIG. 7, a molding layer 140 may be provided on the rear side of the display device 110 in a state in which the assembly having the display device 110 and the printed circuit board 120 combined with each other is provided on the front cover 130.

**.** The molding layer 140 may include a curable material. For example, the molding layer 140 may include an ultraviolet (UV) curable material. UV-curable materials are materials that exhibit high intermolecular bonding strength through chemical reactions when exposed to ultraviolet rays and include, for example, polyacrylate-based materials such as unsaturated polyester-based materials, polyester acrylates, epoxy acrylates, and urethane acrylates. However, the present disclosure is not limited thereto.

**.** The molding layer 140 may be a layer that is cured by radiating ultraviolet rays to a coating layer formed by applying a UV-curable material to the display device 110.

**.** For example, the molding layer 140 may be formed to cover the rear surface of the printed circuit board 120. In this case, as shown in FIG. 8, the area of the rear surface of the printed circuit board 120 may be smaller than the area of the rear surface of the display device 110, and the molding layer 140 may be formed to cover both the rear surface of the printed circuit board 120 and the rear surface of the display device 110. Here, the side of the display device 110 and the side of the molding layer 140 may be formed to be on the same plane.

**.** In addition, the flexible connection structure 40 may be formed to connect the display device 110 and the printed circuit board 120, with at least a portion exposed outside the molding layer 140.

**.** Furthermore, according to an embodiment, the molding layer 141 may be formed to have different heights for different areas of the printed circuit board 120.

**.** For example, referring to FIG. 9, the molding layer 141 may be formed to have a first height for an area corresponding to a first area of the printed circuit board 120, and a second height different from the first height for an area corresponding to a second area different from the first area of the printed circuit board 120.

**.** Various components CP may be provided on the rear surface of the printed circuit board 120. In this case, the height of at least one first component provided in the first area of the printed circuit board 120 may be less than the height of at least one second component provided in the second area of the printed circuit board 120. Additionally, the first height of the area of the molding layer 141 corresponding to the first area of the printed circuit board 120 may be lower than the second height of the area corresponding to the second area of the printed circuit board 120.

**.** As described above, the molding layer 141 may be formed such that the area corresponding to a higher component CP among the plurality of components CP provided on the rear side of the printed circuit board 120 is higher, and the area corresponding to a lower component is lower, and thus the weight of the molding layer 141 can be decreased and the consumption of curable material can be reduced. This can reduce manufacturing costs.

**.** Further, referring to FIG. 10, according to another embodiment, an additional molding layer 142 may be provided on the molding layer 141 formed to have different heights depending on the area.

**.** The front surface of the additional molding layer 142 may have a shape corresponding to the rear surface shape of the molding layer 141 formed to have different heights depending on the area. Alternatively, the rear surface of the additional molding layer 142 may have a flat shape. In this case, the side of the additional molding layer 142 may be formed to be on the same plane as the side of the display device 110.

**.** In this case, the molding layer 141 may include a first UV-curable material having a first viscosity, and the additional molding layer 142 may include a second UV-curable material having a second viscosity lower than the first viscosity.

**.** For example, the molding layer 141 may be a layer formed by curing a coating layer formed by applying the first UV-curable material to the display device 110 by radiating ultraviolet light to the coating layer. Additionally, the additional molding layer 142 may be a layer formed by curing a coating layer formed by applying the second UV-curable material to the molding layer 141 by radiating ultraviolet light to the coating layer.

**.** In this manner, the molding layer 141 in contact with the printed circuit board 120 is formed using the first UV-curable material with relatively high viscosity, thereby minimizing the impact of external shock on at least one component CP on the printed circuit board 120.

**.** At the same time, by covering the molding layer 141 with the second UV-curable material with relatively low viscosity and forming the additional molding layer 142 having a flat back surface, the back surface of the assembly in which the display device 110 and the printed circuit board 120 are combined becomes flat, making it easier to provide other additional components on the assembly. Here, other additional components may include, for example, a battery.

**.** Here, since the additional molding layer 142 does not come into direct contact with at least one component CP on the printed circuit board 120, the additional molding layer may require a lower shock absorption effect compared to the molding layer 141. Accordingly, as described above, the additional molding layer 142 can be formed using a low-viscosity UV-curable material that incurs relatively low costs.

**.** In addition, according to another embodiment, a molding layer 143 may be formed to have a step in an area corresponding to the area between a plurality of components CP provided on the back side of the printed circuit board 120. For example, referring to FIG. 11, a plurality of components having relatively low heights may be distributed in an area on the back of the printed circuit board 120. In this case, a plurality of components having similar heights distributed in an area may be spaced apart by a predetermined interval, and the molding layer 143 may be formed to have a step in an area corresponding to the predetermined interval between the components. Accordingly, the molding layer 143 can be made lighter, and the consumption of curable material can be reduced, thereby decreasing manufacturing costs.

**.** Referring to FIG. 12, the electronic shelf label 100 may further include a rear cover 150 that is provided on the rear side of the display device 110 and combined with the front cover 130. The molding layer 140 is omitted in FIG. 12 for convenience of description.

**.** The perimeter of the front side of the rear cover 150 and the protrusion 133 of the front cover 130 may come into contact with each other, and an adhesive member may be provided therebetween such that the rear cover 150 and the front cover 130 can be joined. In this case, the adhesive member may include a double-sided tape. However, the present disclosure is not limited thereto, and the rear cover 150 and the front cover 130 may also be joined to each other through a hook structure that connects the rear cover 150 and the front cover 130.

**.** Referring to FIG. 13, according to another embodiment, a molding layer 144 may be formed to cover the rear side of the display device 110. The printed circuit board 120 may be provided on the rear surface of the molding layer 144.

. In this case, the front side of the display device 110 may be provided to come into contact with the rear side of the front cover 160. An adhesive member is provided between the front edge region of the display device 110 and a region of the front cover 160 facing the front edge region of the display device 110, and thus the front cover 160 and the display device 110 can be combined. Unlike the front cover 130 of FIG. 12, the front cover 160 may have a flat plate shape. That is, the front cover 160 may be designed to have a structure in which no protrusions are formed on the edges.

**.** However, the present disclosure is not limited thereto, and a structure in which the molding layer 144 and additional molding layers 145 and 146 described with reference to FIG. 13 to FIG. 15 are formed may be applied to the front cover 130 of FIG. 12. A structure in which the molding layer 144 and the additional molding layers 145 and 146 are applied to the front cover 160 in which no protrusions are formed on the edges will be described below.

**.** The area of the rear surface of the front cover 160 may be greater than the area of the rear surface of the display device 110, and the molding layer 144 may be formed to cover both the rear surface of the front cover 160 and the rear surface of the display device 110. Here, the side of the front cover 160 and the side of the molding layer 144 may be formed to be on the same plane.

**.** Additionally, the flexible connection structure 40 may be formed to connect the display device 110 and the printed circuit board 120, with at least a portion exposed outside the molding layer 144.

**.** Referring to FIG. 14, according to an embodiment, an additional molding layer 145 may be provided on the rear surface of the printed circuit board 120 that is provided on the rear surface of the molding layer 144. The additional molding layer 145 may cover the rear surface of the printed circuit board 120. Additionally, the area of the rear surface of the printed circuit board 120 may be less than the area of the rear surface of the molding layer 144, and the additional molding layer 145 may be formed to cover both the rear surface of the printed circuit board 120 and the rear surface of the molding layer 144. Here, the side of the additional molding layer 145 and the side of the molding layer 144 may be formed to be provided on the same plane. Here, the viscosity of the first UV-curable material used to form the additional molding layer 145 may be higher than the viscosity of the second UV-curable material used to form the molding layer 144.

**.** Referring to FIG. 15, according to an embodiment, an additional molding layer 146 may be provided on the printed circuit board 120 provided on the molding layer 144 such that the additional molding layer 146 has different heights depending on the area.

**.** For example, the additional molding layer 146 may be formed to have a first height for an area corresponding to a first area of the printed circuit board 120, and a second height different from the first height for an area corresponding to a second area different from the first area of the printed circuit board 120.

**.** Various components CP may be provided on the rear surface of the printed circuit board 120. In this case, the height of at least one first component provided in the first area of the printed circuit board 120 may be lower than the height of at least one second component provided in the second area of the printed circuit board 120. Additionally, the first height of the area of the additional molding layer 146 corresponding to the first area of the printed circuit board 120 may be lower than the second height of the area corresponding to the second area of the printed circuit board 120.

**.** In this manner, the additional molding layer 146 is formed such that the area corresponding to a higher component CP among the plurality of components CP provided on the rear side of the printed circuit board 120 is higher, and the area corresponding to a lower component CP is lower, thereby making the additional molding layer 145 lighter and reducing the consumption of curable material, resulting in decrease in the manufacturing costs.

**.** Here, the viscosity of the first UV-curable material used to form the additional molding layer 146 may be higher than the viscosity of the second UV-curable material used to form the molding layer 144.

**.** In addition, as illustrated in FIG. 14 and FIG. 15, the durability of the display device 110 and the printed circuit board 120 can be improved according to a double molding structure in which the rear surface of the display device 110 is covered by the molding layer 144 and the rear surface of the printed circuit board 120 is covered by the additional molding layers 145 and 146.

### . - Method S100 for manufacturing electronic shelf label

**.** Referring to FIG. 16, a method S100 for manufacturing the electronic shelf label according to an embodiment may include the steps of connecting the display device 110 and the printed circuit board 120 (S101), forming the molding layer 140 on the rear surface of the printed circuit board 120 (S103), providing the front cover 130 on the front surface of the display device 110 (S105), and combining the rear cover 150 that covers the rear surface of the display device 110 with the front cover 130 (S107).

. In step S101, the display device 110 capable of displaying product-related information and the printed circuit board 120 for driving the display device 110 may be electrically connected.

**.** For example, the flexible connection structure 40 may be used to connect the display device 110 and the printed circuit board 120 facing each other.

. In step S103, a UV-curable material may be applied to the rear surface of the printed circuit board 120 in order to form the molding layer 140 on the rear surface of the printed circuit board 120. Subsequently, the UV-curable material applied to the rear surface of the printed circuit board 120 can be cured to form the molding layer 140.

**.** Referring to FIGS. 17 and 18, step S103 may include step S1031 of measuring a first height of at least one first component provided in a first area of the printed circuit board 120, step S1033 of adjusting the height of a molding material supply device SP based on the first height to spray a molding material onto the at least one first component, step S1035 of measuring a second height of at least one second component provided in a second area different from the first area of the printed circuit board 120, step S1037 of adjusting the height of the molding material supply device SP based on the second height to spray the molding material onto the at least one second component, and step S1039 curing the molding material sprayed onto the at least one first component and the at least one second component.

**.** In performing step S103, a distance sensor OD capable of two-dimensional movement on a plane parallel to the rear surface of the printed circuit board 120 and the molding material supply device SP may be used. The distance sensor OD and the molding material supply device SP may be formed as a single unit and move simultaneously, but the present disclosure is not limited thereto and the distance sensor OD and the molding material supply device SP may be controlled to move independently of each other.

**.** In step S1031, the first height H1 of at least one first component provided in the first area of the printed circuit board 120 may be measured by an optical method.

**.** For example, referring to FIG. 18, the first height H1 of at least one first component provided in the first area of the printed circuit board 120 may be measured using the movable distance sensor OD capable of moving left and right on the printed circuit board 120. In this case, the distance to one side of the printed circuit board 120 is measured by the distance sensor OD, and the distance to at least one first component provided in the first area is additionally measured from this distance, and thus the first height H1 of the at least one first component can be calculated.

**.** In step S1033, after the height of the molding material supply device SP is adjusted such that the molding material supply device SP is located within a predetermined critical distance from the first height H1 of the at least one first component, the molding material supply device SP may be controlled to spray the molding material.

**.** In this case, a sufficient amount of molding material can be sprayed onto the surface of at least one first component to form a thin film. Accordingly, unlike the general method of supplying a molding material by liquid injection, by providing the molding material to the at least one first component through a spraying method, the molding layer 140 in the form of a thin film having a height equal to the height of the at least one first component can be formed.

**.** Here, the molding material may include a UV-curable material. The UV-curable material may include, for example, unsaturated polyester-based materials or polyacrylate-based materials such as polyester acrylate, epoxy acrylate, or urethane acrylate, but the present disclosure is not limited thereto.

**.** In step S1035, the second height H2 of at least one second component provided in the second area different from the first area of the printed circuit board 120 may be measured through an optical method.

**.** For example, referring to FIG. 18, the distance sensor OD can be used to measure the second height H2 of the at least one second component provided in the second area of the printed circuit board 120. In this case, the distance to one side of the printed circuit board 120 is measured by the distance sensor OD, and the distance to the at least one second component provided in the second area is additionally measured from this distance to calculate the second height H2 of the at least one second component.

**.** In step S1037, after the height of the molding material supply device SP is adjusted such that the molding material supply device SP is located within a predetermined critical distance from the second height H2 of the at least one second component, the molding material supply device SP can be controlled to spray the molding material.

**.** In this case, a sufficient amount of molding material can be sprayed to form a thin film of molding material on the surface of the at least one second component. Accordingly, unlike the general method of supplying a molding material by liquid injection, the molding layer 140 in the form of a thin film having a height equal to the height of the at least one second component can be formed by providing the molding material to the at least one second part through the spraying method.

**.** In step S1039, the molding layer 140 may be formed by curing the molding material sprayed onto the at least one first component and the molding material sprayed onto the at least one second component by radiating ultraviolet light thereto.

**.** The molding layer 140 formed in this manner may have a height in the area corresponding to the area where the at least one first component is provided and a height in the area corresponding to the area where the at least one second component is provided, which are different from each other.

**.** The specific implementations described in the present disclosure are exemplary embodiments and do not limit the scope of the present disclosure. For the sake of brevity, descriptions of conventional electronic components, control systems, software, and other functional aspects of the systems may be omitted. In addition, lines connecting or connecting members between components illustrated in the drawings are merely representative of functional connections and/or physical or circuit connections, and may be replaced or represented as various additional functional connections, physical connections, or circuit connections in an actual device. In addition, unless specifically mentioned as "essential," "important," etc., a component may not be absolutely necessary for the application of the present disclosure.

**.** Although the present disclosure has been described in detail with reference to preferred embodiments of the present disclosure, it will be understood by those skilled in the art or having ordinary knowledge in the art that various modifications and changes can be made to the present disclosure without departing from the spirit and technical scope of the present disclosure as set forth in the claims below. Accordingly, the technical scope of the present disclosure should not be limited to the contents described in the detailed description of the specification, but should be defined by the claims.

## Claims

1. An electronic shelf label (100) comprising:
a display device (110) controlled to display information regarding a product;
a printed circuit board (120) provided on a rear surface of the display device (110) and electrically connected to the display device (110), and having at least one component provided on one surface;
a front cover (130) provided on a front surface of the display device (110);
a molding layer (140) provided on the rear surface of the display device (110); and
a rear cover (150) provided on the rear surface of the display device (110) and coupled with the front cover (130).

2. The electronic shelf label of claim 1, wherein the printed circuit board (120) is provided on the rear surface of the display device (110), and the molding layer (150) covers a rear surface of the printed circuit board (120).

3. The electronic shelf label of claim 1, wherein the area of the rear surface of the printed circuit board (120) is smaller than the area of the rear surface of the display device (110), and the molding layer (140) covers both the rear surface of the printed circuit board (120) and the rear surface of the display device (110).

4. The electronic shelf label of claim 2 or 3, wherein the side of the display device (110) and the side of the molding layer (140) are provided on the same plane.

5. The electronic shelf label of claim 2 or 3, wherein the molding layer (140) has a first height for an area corresponding to a first area of the printed circuit board (120) and has a second height different from the first height for an area corresponding to a second area different from the first area of the printed circuit board (120).

6. The electronic shelf label of claim 5, wherein the height of at least one first component provided in the first area of the printed circuit board (120) is lower than the height of at least one second component provided in the second area of the printed circuit board (120), and the first height of the molding layer (140) is lower than the second height of the molding layer (140).

7. The electronic shelf label of claim 1, wherein the molding layer (140) covers the rear surface of the display device (110), and the printed circuit board (120) is provided on the rear surface of the molding layer (140).

8. The electronic shelf label of claim 7, further comprising an additional molding layer (145) covering the rear surface of the printed circuit board (120).

9. The electronic shelf label of claim 8, wherein the additional molding layer (145) has a first height for an area corresponding to a first area of the printed circuit board (120), and has a second height different from the first height for an area corresponding to a second area different from the first area of the printed circuit board (120).

10. The electronic shelf label of claim 9, wherein the height of at least one first component provided in the first area of the printed circuit board (120) is lower than the height of at least one second component provided in the second area of the printed circuit board (120), and the first height of the additional molding layer (145) is lower than the second height of the molding layer 145.

11. A method for manufacturing an electronic shelf label (100) controlled by a server 200 to display information regarding a product, the method comprising:
connecting a display device (110) and a printed circuit board (120);
forming a molding layer (140) on a rear surface of the printed circuit board (120);
providing a front cover (130) on a front surface of the display device (110); and
coupling a rear cover (150) covering the rear surface of the display device (110) with the front cover (130).

12. The method of claim 11, wherein the forming a molding layer (140) comprises:
measuring a first height of at least one first component provided in a first area of the printed circuit board (120);
adjusting the height of a molding material supply device (SP) based on the first height and spraying a molding material onto the at least one first component;
measuring a second height of at least one second component provided in a second area different from the first area of the printed circuit board (120);
adjusting the height of the molding material supply device (SP) based on the second height and spraying the molding material onto the at least one second component; and
curing the molding material sprayed onto the at least one first component and the at least one second component.
